# EUROPEAN PATENT APPLICATION

(11) **EP 4 733 929 A1**
(43) Date of publication of application: **29.04.2026**
(21) Application number: 24830066.7
(22) Date of filing: 10.04.2024
(51) Int. Cl.: G06F 8/40, G06F 9/54

(54) **OBJECT PROCESSING METHOD AND COMPUTING DEVICE**

(30) Priority: 26.06.2023 CN 202310761011
(71) Applicant: Cloud Intelligence Assets Holding (Singapore) Private Limited, Singapore 189554 (SG)
(72) Inventor: FANG, Xing, Hangzhou, Zhejiang 310030 (CN); YANG, Hang, Hangzhou, Zhejiang 310030 (CN); FANG, Zhiyong, Hangzhou, Zhejiang 310030 (CN)
(74) Representative: Barker Brettell LLP
(86) International application number: PCT/CN2024/087009
(87) International publication number: WO 2025/001416

(57) **Abstract**

Embodiments of the present application provide an object processing method and a computing device. According to a serialization order of a second object associated with a first object in an object graph, a serialization number of the second object is determined. The serialization number of the second object is used as pointer field encoding data of the first object. According to the serialization order of different objects in the object graph, at least some objects to be serialized are determined. Based on value field encoding data and pointer field encoding data of the at least some objects, serialized data of the at least some objects is generated. The serialized data is transmitted to a receiving end. The receiving end is configured to obtain the object graph in combination with a deserialization result of at least one piece of serialized data corresponding to the object graph. Technical solutions according to the embodiments of the present application reduce end-to-end delay and improve processing efficiency.

## Description

This application claims priority to Chinese Patent Application No. 202310761011.0, filed with the China National Intellectual Property Administration on June 26, 2023 and entitled "OBJECT PROCESSING METHOD AND COMPUTING DEVICE", which is incorporated herein by reference in its entirety.

### TECHNICAL FIELD

Embodiments of the present application relate to the field of computer technologies, and in particular, to an object processing method and a computing device.

### BACKGROUND

To facilitate cross-platform storage and network transmission, serialization/deserialization processing needs to be performed on an object. The serialization processing is a process of converting an object into transportable byte information, and the deserialization is a process of restoring byte information to an object. A group of objects having an association relationship constitute an object graph. When any object is serialized, if the object is associated with another object, the another object is also serialized. Therefore, in practical applications, serialization/deserialization of the object graph is involved.

A data format of each object in the object graph in a memory usually includes a value field and a pointer field. The value field stores object data, while the pointer field stores memory addresses of sub-objects associated with each object. In some cases, when the serialization processing is performed on the object graph, encoding data of each object needs to be temporarily stored in a cache. In this case, since the pointer field stores the memory address of the sub-object, the memory address needs to be encoded as a relative offset of the sub-object in the cache. After the object graph is completely encoded, generated serialized data is sent to a receiving end. In a process of performing the deserialization processing to restore the object graph, the receiving end decodes pointer field encoding data in the serialized data, that is, the relative offset, as a memory address after the deserialization.

However, for the processing manner in some of the cases described above, end-to-end delay is relatively large, which affects processing efficiency.

### SUMMARY

Embodiments of the present application provide an object processing method and a computing device, to resolve a technical problem in related art that end-to-end delay is relatively large and thus affects processing efficiency.

According to a first aspect, an embodiment of the present application provides an object processing method, including: determining, according to a serialization order of a second object associated with a first object in an object graph, a serialization number of the second object; using the serialization number of the second object as pointer field encoding data of the first object; determining, according to a serialization order of different objects in the object graph, at least some objects to be serialized in the object graph; generating, based on value field encoding data and pointer field encoding data of the at least some objects, serialized data of the at least some objects; and transmitting the serialized data to a receiving end, where the receiving end is used to obtain the object graph in combination with a deserialization result of at least one piece of serialized data corresponding to the object graph.

According to a second aspect, an embodiment of the present application provides an object processing method, including: obtaining serialized data transmitted by a sending end, where the serialized data is generated based on value field encoding data and pointer field encoding data of at least some objects in an object graph, and the pointer field encoding data is a serialization number of an associated sub-object; performing deserialization processing on the serialized data, to determine memory addresses of the at least some objects, and value field data respectively corresponding to the value field encoding data of the at least some objects; writing the value field data respectively corresponding to the at least some objects into respective memory addresses; and writing, in combination with at least one piece of serialized data corresponding to the object graph, a memory address of a sub-object associated with pointer encoding data of any object as pointer field data into a memory address of the object.

According to a third aspect, an embodiment of the present application provides a computing device, including a processing component and a storage component, where the storage component stores one or more computer instructions, and the one or more computer instructions are used to be invoked and executed by the processing component, to implement the object processing method according to the first aspect above or implement the object processing method according to the second aspect above.

According to a fourth aspect, an embodiment of the present application provides a computer readable storage medium, storing a computer program, where the computer program, when executed by a computer, implements the object processing method according to the first aspect above or implements the object processing method according to the second aspect above.

These aspects or other aspects of the present application will be more concise and understandable in the description of the following embodiments.

### BRIEF DESCRIPTION OF DRAWINGS

In the accompanying drawings, same reference signs throughout a plurality of accompanying drawings represent same or similar parts or elements, unless otherwise specified. The accompanying drawings are not necessarily drawn to scale. It should be understood that these accompanying drawings only describe some implementations disclosed according to the present application, and should not be construed as limiting the scope of the present application.

To illustrate the technical solutions in the embodiments of the present application or in related art more clearly, accompanying drawings required for describing the embodiments or the related art will be introduced briefly in the following. It is apparent that, the accompanying drawings in the following description are some embodiments of the present application, and those of ordinary skill in the art can also derive other accompanying drawings from these accompanying drawings without creative efforts.
FIG. 1 shows a system architecture diagram to which a technical solution according to an embodiment of the present application is applied.
FIG. 2 shows a flowchart of an embodiment of an object processing method according to the present application.
FIG. 3 shows a schematic diagram representing an object association relationship in a practical application according to an embodiment of the present application.
FIG. 4A to FIG. 4C respectively show schematic diagrams of a predetermined data format in a practical application according to an embodiment of the present application.
FIG. 4D to FIG. 4F show schematic diagrams of serialized data in a practical application according to an embodiment of the present application.
FIG. 4G shows a schematic diagram of metadata association in a practical application according to an embodiment of the present application.
FIG. 5 shows a flowchart of another embodiment of an object processing method according to the present application.
FIG. 6A shows a schematic diagram of a memory data format in a practical application according to an embodiment of the present application.
FIG. 6B shows a schematic diagram showing a serialization/deserialization operation in a practical application according to an embodiment of the present application.
FIG. 7 shows a schematic structural diagram of an embodiment of an object processing apparatus according to the present application.
FIG. 8 shows a schematic structural diagram of another embodiment of an object processing apparatus according to the present application.
FIG. 9 shows a schematic structural diagram of an embodiment of a computing device according to the present application.

### DESCRIPTION OF EMBODIMENTS

To make a person skilled in the art better understand the solutions of the present application, the technical solutions in the embodiments of the present application will be described clearly and completely below with reference to the accompanying drawings in the embodiments of the present application.

In some procedures described in the specification, the claims, and the accompanying drawings of the present application, a plurality of operations occurring in a specific sequence are included. However, it should be clearly understood that the operations may not be performed in the sequence in which the operations occur in this specification or performed in parallel. Sequence numbers of the operations, such as 101 and 102, are merely used for distinguishing different operations, and the sequence numbers do not indicate any execution sequence. In addition, these procedures may include more or fewer operations, and the operations may be performed in order or in parallel. It should be noted that, the descriptions of "first", "second", and the like herein are used for distinguishing different messages, devices, modules, and the like, and do not indicate a sequence, and "first" and "second" are not limited to being of different types.

Technical solutions in embodiments of the present application may be applied to an application scenario of serialization/deserialization for an object graph, and in particular, to an application scenario of the serialization/deserialization involved in a public cloud.

End-to-end delay caused by the serialization/deserialization is very important to user experience, processing performance, and the like. For example, in a scenario of microservice, there are often circular calls among a plurality of microservices. As a result, when a microservice sends a request to another microservice, the another microservice may respond to the request until calling other microservices for corresponding processing. The call among microservices involves object transmission. In a scenario of cyclic call, due to the end-to-end delay, response time for a request is longer. Therefore, how to reduce the end-to-end delay and improve transmission efficiency has become a technical problem to be resolved by a person skilled in the art.

During implementation of the present application, an inventor finds that: currently, serialization processing is performed on an object graph; after all objects are serialized and written into a cache, there is a need to traverse all objects to determine a relative offset of a sub-object, and then encode pointer field data of each object as the relative offset; and after a receiving end obtains the serialized data of the object graph, after all the objects are deserialized, there is a need to traverse all the objects, and then decode a relative offset of each object as a memory address obtained by deserialization. It can be seen that this process usually takes a long time, resulting in end-to-end delay. To improve and reduce the end-to-end delay and improve the processing efficiency, the inventor provides a technical solution of the present application through a series of studies. In an embodiment of the present application, a serialization number corresponding to a serialization order is used as pointer field encoding data, and the serialization order is used to associate an object with a sub-object. Compared with a manner using the relative offset, there is no need to traverse all objects to determine the relative offset of the sub-object. Therefore, graph traversal operations can be reduced, and operation complexity can be reduced, thereby helping to reduce the end-to-end delay and improve transmission efficiency. Moreover, by using the serialization order to associate the object with the sub-object, some objects can be serialized/deserialized, without waiting for all objects to be processed completely. Therefore, the end-to-end delay can be further reduced, and the transmission efficiency can be improved.

The technical solutions in the embodiments of the present application will be described clearly and completely below with reference to the accompanying drawings in the embodiments of the present application. Ii is apparent that, the described embodiments are merely some of the embodiments of the present application, rather than all of the embodiments. All other embodiments obtained by a person skilled in the art based on the embodiments of the present application without making creative efforts shall fall within the protection scope of the present application.

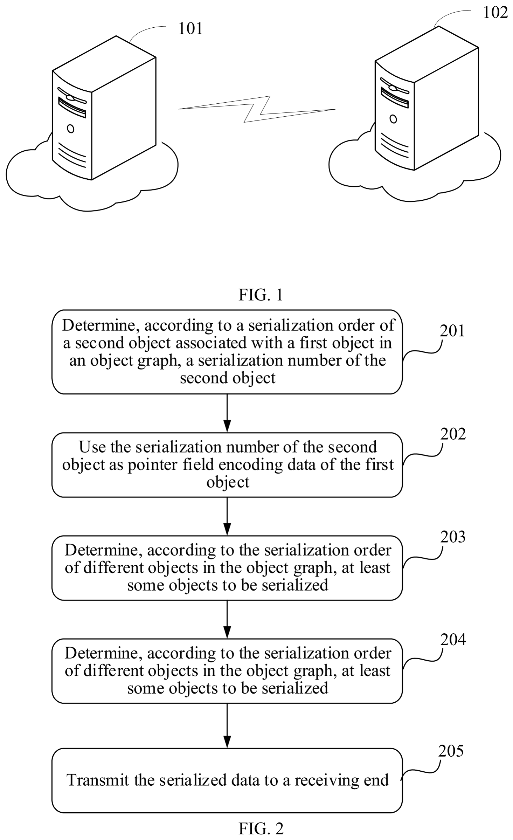

FIG. 1 shows a system architecture diagram to which a technical solution according to an embodiment of the present application may be applied. The system architecture may include a sending end 101 and a receiving end 102.

In a practical application, the sending end 101 and the receiving end 102 may be a client, a server end or an application in a server end, etc. Although the sending end or the receiving end is represented in a form of a server end in FIG. 1, it may be understood that the present application is not limited thereto.

A connection may be established between the sending end 101 and the receiving end 102 through a network. The network provides a medium of a communication link between the sending end 101 and the receiving end 102. The network may include various connection types, for example, a wired communication link, a wireless communication link, or an optical cable, among others.

A process of performing interaction communication between the sending end 101 and the receiving end 102 involves network transmission of an object graph and performing the network transmission on the object graph involves serialization/deserialization processing.

When the sending end 101 or the receiving end 102 is implemented as a client, the client may be a browser, an APP (Application, Application), or a web application such as a H5 (HyperText Markup Language 5, HyperText Markup Language 5) application, a light application (also referred to as a mini program, a lightweight application), a cloud application, or the like. The client may be deployed in an electronic device, and needs to run depending on the device or some apps in the device.

When the sending end 101 or the receiving end 102 is implemented as a server end, the server end may be implemented as a distributed server cluster including a plurality of servers, or may be implemented as a single server. The server may alternatively be a server of a distributed system, or a server combined with a block chain. The server may alternatively be a cloud server providing basic cloud computing services such as a cloud service, a cloud database, cloud computing, a cloud function, cloud storage, a network service, cloud communication, a middleware service, a domain name service, a security service, a content delivery network (Content Delivery Network, CDN), as well as a big data and artificial intelligence platform, or be an intelligent cloud computing server or an intelligent cloud host with an artificial intelligence technology.

It should be understood that the numbers of the sending end and the receiving end in FIG. 1 are merely schematic. There may be any number of sending ends and receiving ends according to an implementation requirement.

It should be noted that the embodiment of the present application may involve use of user data. In a practical application, user-specific personal data may be used in the solution described herein in a case in which applicable legal and legal requirements of a country are satisfied (for example, the user explicitly agrees, or the user is actually notified) and within a scope allowed by the applicable legal and legal requirements.

Implementation details of the technical solutions of the embodiments of the present application are set forth in detail below.

FIG. 2 is a flowchart of an embodiment of an object processing method according to an embodiment of the present application. A technical solution of this embodiment is performed by a sending end, and the method may include the following several steps 201 to 205.

201: determine, according to a serialization order of a second object associated with a first object in an object graph, a serialization number of the second object.

The object graph may include a plurality of objects having an association relationship. In a case where one object is associated with (or points to) another object, for ease of distinction, in this embodiment of the present application, the another object is also referred to as a sub-object of the object.

When serialization processing is performed on the object graph, the serialization processing, that is, encoding processing may be performed, on each object sequentially starting from the first object of the object graph. Therefore, the serialization order of each object may be determined according to the association relationship of the plurality of objects in the object graph.

The first object may be any object currently encoded in the object graph, and the second object is any sub-object associated with the first object.

A corresponding serialization number may be determined according to the serialization order of the first object. Different serialization orders result in different serialization numbers. For example, the serialization number may be represented by using an integer character. For example, starting from 0 or 1, an object on which the serialization processing is performed first is represented. Certainly, the serialization number may alternatively be represented by another type of character, and is not limited to starting from 0 or 1, which is not limited in the present application.

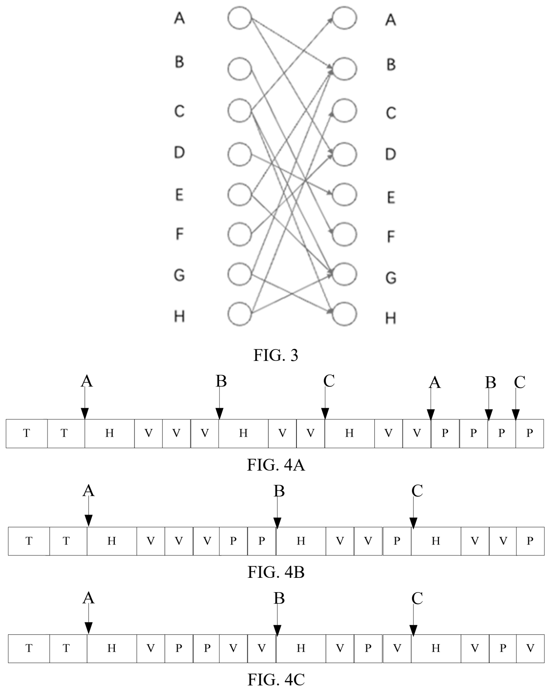

For ease of understanding, it is assumed that the object graph includes eight objects: A, B, C, D, E, F, G, and H. It is assumed that an object A is a first serialized object. The association relationship among the eight objects may be shown in FIG. 3, and arrow pointing in FIG. 3 indicates another object that an object cites.

The object A is the first serialized object, and the serialization number corresponding to the object A is 0.

The object A is associated with two sub-objects: an object B and an object D. According to a data type or an appearance order of the object B and the object D in code call of the object A, it may be determined that the object B is a next serialized object, and the object D is a next serialized object after the object B. Therefore, the serialization number of the object B is 1, and the serialization number of the object D is 2.

The object B is associated with one object: an object F, and the serialization number of the object F is 3.

By analogy, the object D is associated with one object: an object E, and the serialization number of the object E is 4.

The object F is associated with one object: the object D. Since the serialization processing has been performed on the object D, the serialization number is 2.

The object E is associated with two objects: the object B and the object G. Since the serialization processing is performed on the object B, the serialization number of the object B is 1. A serialization code of the object G is 5.

The object G is associated with two objects: the object B and an object H. The serialization processing has been performed on the object B, and the serialization number of the object B is 1. The serialization code of the object H is 6.

The object H is associated with two objects: the object G and the object C. The serialization processing has been performed on the object G, and the serialization number of the object G is 5. The serialization code of the object C is 7.

The object C is associated with three objects: the object A, the object G, and the object H. The serialization code of the object A is 0, the serialization code of the object G is 5, and the serialization code of the object H is 6.

In combination with the foregoing description, the serialization order of the eight objects is A → B → D → F → E → G → H → C.

It should be noted that the serialization order of each object may be determined one by one in a serialization process of the object graph, and may not need to be predetermined. The foregoing description is merely for ease of understanding.

202: use the serialization number of the second object as pointer field encoding data of the first object.

Each object in a data format in a memory usually includes object header information and instance data. The instance data may include at least one value field and at least one pointer field. The pointer field data is a memory address of the sub-object. When performing the serialization processing, in addition to encoding the value field data, the pointer field data also needs to be encoded.

The object header information of each object in the memory may usually include, for example, Mark Word (runtime data of the object itself) and Klass Pointer (type pointer). The object header information of each object, as well as a position, a type, and the like respectively corresponding to at least one value field and at least one pointer field included in the instance data of each object may be, as metadata, registered and saved in different ends in advance. Where the position and the type respectively corresponding to the at least one value field and the at least one pointer field included in the instance data of each object may be represented in a bitmap form, for example, 00110, where 0 represents that the position corresponds to the value field, and 1 represents that the position corresponds to the pointer field.

In the embodiment of the present application, the serialization order may be used to associate an object with a sub-object thereof. Therefore, the pointer field data corresponding to the second object in the first object may be modified as the serialization number of the second object, and the serialization number is used as the pointer field encoding data.

Still using the eight objects corresponding to FIG. 3 as an example, the pointer field data corresponding to the object B in the object A is encoded as the serialization number 1, the pointer field data corresponding to the object D is encoded as the serialization number 2, that is, the pointer field encoding data of the object A is 1 and 2, and so on. The pointer field encoding data of the object B is 3. The pointer field encoding data of the object D is 4. The pointer field encoding data of the object F is 2. The pointer field encoding data of the object E is 1 and 5. The pointer field encoding data of the object G includes 1 and 6. The pointer field encoding data of the object H includes 5 and 7. The pointer field encoding data of the object C includes 0, 5, and 6.

203: determine, according to the serialization order of different objects in the object graph, at least some objects to be serialized in the object graph.

204: generate, based on value field encoding data and pointer field encoding data of the at least some objects, serialized data of the at least some objects.

In some implementations, all objects in the object graph may be used as the objects to be serialized. Therefore, the serialized data may be generated based on the value field encoding data and the pointer field encoding data of all the objects.

In some other implementations, the embodiment of the present application uses the serialization order to associate the object with the sub-object. Therefore, it is unnecessary to wait for all objects of the objects to be encoded completely, and a segment of serialized data may be generated based on the value field encoding data and the pointer field encoding data of some objects.

Therefore, one object graph may correspond to at least one piece of serialized data.

The value field encoding data of each object may be obtained by encoding the value field data, to reduce data transmission volume. Certainly, the value field data may alternatively be directly used as the value field encoding data, and so on, which is not limited in the present application.

The serialized data may further include header encoding information generated based on the object header information of each object. The header encoding information of each object may be associated with metadata of each object, and may be specifically associated with a metadata pointer of each object. The metadata pointer may point to saved metadata of each object. The metadata of each object may include object header information, as well as a location, a type, and the like respectively corresponding to a value field and a pointer field.

The header encoding information may use any identification information associated with the metadata pointer. The header encoding information and corresponding metadata pointer may be saved in a type table, and the type table may be registered and saved in different ends in advance, so that the serialized data may include only the header encoding information of each object.

Moreover, the serialized data may further include at least one piece of graph attribute information corresponding to at least some objects. The at least one piece of graph attribute information may include, for example, one or more of a graph size and the number of objects, etc. The at least one piece of graph attribute information may be used to instruct the receiving end to allocate corresponding memory space or the like. Where the graph size refers to a size of occupied memory.

Therefore, in an embodiment, the serialized data may be generated based on the value field encoding data, the pointer field encoding data, the header encoding data, and the at least one piece of graph attribute information of the at least some objects. There may be a plurality of implementations for a data format of the serialized data. Details are introduced in the following embodiment.

205: transmit the serialized data to a receiving end.

The serialized data may be transmitted to a receiving end immediately after being generated. Where each piece of serialized data may be transmitted to the receiving end upon generation, to reduce cache occupation.

The receiving end may obtain the object graph by using a deserialization result of at least one piece of serialized data corresponding to the object graph.

In the foregoing serialized data, the value field encoding data may be deserialized as the value field data. The pointer encoding data may be used to establish a mapping relationship among a memory address, an offset address, and the pointer encoding data. The mapping relationship respectively corresponding to the at least one piece of serialized data may be searched for a memory address to which the pointer encoding data is mapped, and the memory address to which the pointer encoding data is mapped is used as the pointer field data as which the pointer encoding data is deserialized. A specific deserialization process is introduced in detail in the following embodiment.

In this embodiment, a serialization number corresponding to a serialization order is used as pointer field encoding data, and the serialization order is used to associate an object and a sub-object. Compared with a manner using the relative offset, graph traversal operations can be reduced, and operation complexity can be reduced, thereby helping to reduce the end-to-end delay and improve transmission efficiency. Moreover, by using the serialization order to associate the object and the sub-object, the object graph can be segmented, and at least some objects can be serialized/deserialized without waiting for all objects to be processed completely. Therefore, the end-to-end delay can be further reduced, and the transmission efficiency can be improved.

From the foregoing description, it can be known that the serialized data may be generated based on the value field encoding data and the pointer field encoding data of some objects. When performing the serialization processing, an encoding result of each object needs to be temporarily saved in a cache. Therefore, in an implementation, the determining, according to the serialization order of different objects in the object graph, at least some objects to be serialized may include: writing, according to the serialization order of the different objects in the object graph, the value field encoding data and the pointer field encoding data of the first object into a first cache; and using, when the first cache reaches a predetermined cache size or a number of objects that have been written reaches a predetermined number, the objects that have been written into the first cache as the at least some objects to be serialized.

That is, when encoding each object, the value field encoding data and the pointer field encoding data of the first object may be written into the first cache. In addition, the header encoding information of the first object may also be written into the first cache.

The first cache is a cache (cache) used for performing the serialization processing in the receiving end.

Upon the first cache reaches the predetermined cache size or the number of objects that have been written reaches the predetermined number, all objects that have been written in the first cache may be used as the at least some objects to be serialized for generating a piece of serialized data.

This predetermined cache size or predetermined number may be determined in combination with a maximum cache size of the sending end or the receiving end, and so on, to avoid a data overflow problem, etc., or may be determined in combination with an actual delay requirement, and so on, which is not limited in the present application.

In this embodiment, upon a cache size occupied by an encoded object reaches the predetermined cache size or the number of objects reaches the predetermined number, the serialized data may be generated. This serialized data may be sent to the receiving end in time, so that the first cache may continue to be used to serialize the remaining objects. Each object is encoded according to the serialization order, and an encoding result is written into the first cache. The encoding result may include the value field encoding data and the pointer field encoding data, and may further include the header encoding data and the like.

As another implementation, the method may further include: segmenting, according to the serialization order of the different objects in the object graph and in combination with the predetermined cache size or a predetermined number of objects, the object graph, to obtain a plurality of sub-object graphs.

That is, the predetermined number of objects may be first obtained from the object graph according to the predetermined cache size, and the object graph is divided into a plurality of sub-objects. For example, the object graph including eight objects corresponding to the schematic diagram shown in FIG. 3 may be divided into two sub-object graphs: A → B → D → F and E → G → H → C according to the serialization order. According to the object serialization order, the serialization order among the plurality of sub-object graphs may also be determined.

For example, the determining, according to a serialization order of a second object associated with a first object in an object graph, a serialization number of the second object may include: determining, according to the serialization order of the second object associated with the first object in a first sub-object graph, the serialization number of the second object. The determining, according to the serialization order of different objects in the object graph, at least some objects to be serialized may include: using at least one object included in the first sub-object graph as the at least some objects to be serialized.

That is, all objects included in the first sub-object graph are all used as the at least some objects to be serialized.

The first sub-object graph may be any sub-object graph. There may be a plurality of implementations for determining the first sub-object graph. In an implementation, a next first sub-object graph to be serialized may be determined in response to a data transmission operation for a previous second sub-object graph.

The data transmission operation is a processing operation of transmitting the serialized data to a receiving end.

That is, after the serialized data generated from a previous sub-object graph is transmitted to the receiving end, according to the serialization order, a next sub-object graph is also the first sub-object graph.

In still another implementation, parallel processing may be performed on a plurality of sub-object images, so that any sub-object graph may be used as the first sub-object graph. In a case of parallel processing, the serialization order of different objects in the object graph may be predetermined.

In still another implementation, in response to that determining duration for which the previous second object graph is determined as the sub-object graph to be serialized is greater than predetermined duration, a next first sub-object graph to be serialized is determined.

That is, after the previous sub-object graph is determined as the sub-object graph to be serialized, processing on the next sub-object graph may be continued after the predetermined duration. In this implementation case, the serialization order of different objects in the object graph may also be predetermined.

Furthermore, the present application is not limited to the foregoing several implementations. For example, a next first sub-object graph to be serialized may be determined alternatively in response to an encoding completion operation for a last object in the previous second sub-object graph.

It can be known in combination with the foregoing description that the predetermined data format of the serialized data may be preset. There may be a plurality of implementations of the predetermined data format. The predetermined data format may include a header position, a pointer field position, a value field position, an attribute position, and the like corresponding to each object.

Therefore, in some embodiments, the generating, based on value field encoding data and pointer field encoding data of the at least some objects, serialized data of the at least some objects may include: writing the value field encoding data respectively corresponding to the at least some objects into respectively corresponding value field positions in a predetermined data format; writing the pointer field encoding data respectively corresponding to the at least some objects into respectively corresponding pointer field positions in the predetermined data format; writing header encoding information respectively corresponding to the at least some objects into respectively corresponding header positions in the predetermined data format, where the header encoding information is used for associating metadata; and writing at least one piece of graph attribute information corresponding to the at least some objects into an attribute position in the predetermined data format.

There may be a plurality of implementations of the predetermined data format, and the header position and the value field position of each object may be sequentially arranged and combined. Certainly, the header position, the value field position, and the pointer field position of each object may also be combined. The value field position and the pointer field position may be consistent with a layout in the memory. Certainly, the value field position may be arranged first and then the pointer field position may be arranged for combination, and so on.

The attribute position may be arranged at the front of the predetermined data format, and then each object may be sequentially arranged according to the serialization order. Certainly, the attribute position may also be arranged at the end of the predetermined data format, and so on.

For ease of understanding, FIG. 4A, FIG. 4B, and FIG. 4C show three predetermined data formats. Use the three objects A, B and C as examples, where H represents the header position, P represents the pointer field position, V represents the value field position, and T represents a value position. Certainly, the present application is not limited thereto.

In addition, as another implementation, in some embodiments, the generating, based on value field encoding data and pointer field encoding data of the at least some objects, serialized data of the at least some objects includes: combining the value field encoding data and the header encoding data respectively corresponding to each object, to obtain a value field encoding array; combining the pointer field encoding data respectively corresponding to the at least some objects, to obtain a pointer field encoding array; combining at least one piece of graph attribute information corresponding to the at least some objects, to obtain an attribute encoding array; and using the value field encoding array, the pointer field encoding array, and the attribute encoding array as the serialized data.

The header encoding data and the value field encoding data of each object may be arranged and combined to obtain target encoding data of each object. Thereafter, the target encoding data respectively corresponding to the at least some objects may be arranged and combined according to the serialization order, to form the value field encoding array. Similarly, the pointer field encoding data and the at least one piece of graph attribute information may also be respectively combined to obtain an array. The serialized data may alternatively include three arrays and be transmitted to the receiving end, and so on.

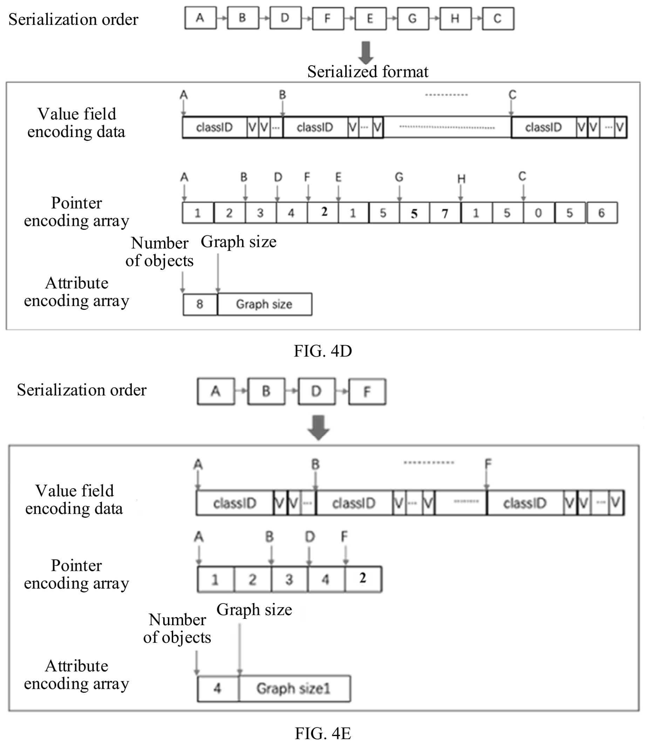

For ease of understanding, still using the object graph corresponding to FIG. 3 as an example, FIG. 4D shows an implementation of serialized data corresponding to the object graph, including value field encoding data, pointer field data, and an attribute encoding array. In the figure, classID indicates the header encoding information, and V indicates the value field encoding data.

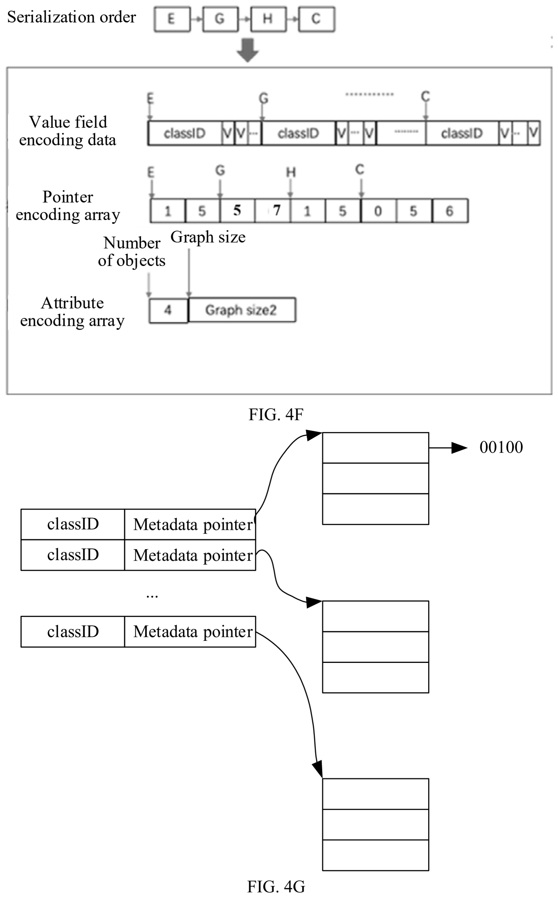

In addition, when the object graph is divided into A → B → D → F and E → G → H → C, FIG. 4E shows the serialized data of the sub-object A → B → D → F, including the corresponding value field encoding data, pointer field data, and attribute encoding array; and FIG. 4F shows serialized data corresponding to the sub-object graph E → G → H → C, including the corresponding value field encoding data, pointer field data, and attribute encoding array.

In addition, it can be known from the foregoing description that, the serialized data may include the header encoding information (classID) generated based on the object header information of each object. The header encoding information of each object may be associated with metadata of each object, and may be specifically associated with a metadata pointer of each object. The metadata pointer may point to saved metadata of each object. The metadata of each object may include object header information, as well as a location, a type, and the like respectively corresponding to a value field and a pointer field. As shown in FIG. 4G, a schematic diagram of association between header encoding information and metadata is shown.

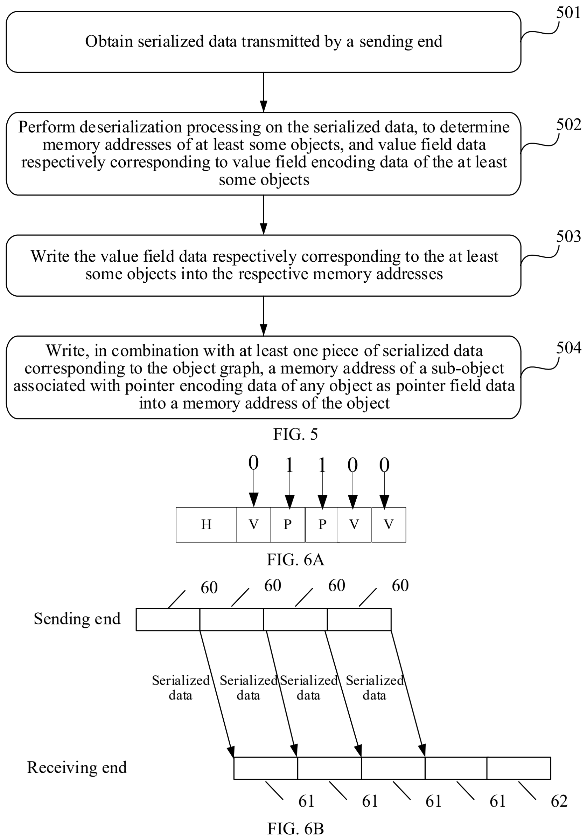

Upon the serialized data is transmitted to the receiving end, the receiving end may perform deserialization processing, to restore the object graph, as shown in FIG. 5, which is a flowchart of another embodiment of an object processing method according to an embodiment of the present application. A technical solution of this embodiment is performed by a receiving end, and the technical solution of the present application is introduced from the perspective of deserialization processing. The method may include the following several steps 501 to 504.

501: obtain serialized data transmitted by a sending end.

The serialized data may be generated based on value field encoding data and pointer field encoding data of at least some objects in an object graph, and the pointer field encoding data is a serialization number of an associated sub-object.

For details of a specific generation manner of the serialized data, refer to the embodiment shown in FIG. 2, and details are not described herein again.

502: perform deserialization processing on the serialized data, to determine memory addresses of at least some objects, and value field data respectively corresponding to value field encoding data of the at least some objects.

503: write the value field data respectively corresponding to the at least some objects into the respective memory addresses.

It can be known from the foregoing description that, at least one piece of serialized data may be correspondingly generated for the object graph. The receiving end may perform the deserialization processing on each piece of serialized data upon receipt, and may not need to wait for all serialized data.

The receiving end needs to allocate appropriate space in a memory to save an object when performing the deserialization processing. Therefore, the memory addresses of the at least some objects respectively in the memory may be determined. In addition, the value field data corresponding to the value field encoding data may also be obtained.

In addition, since the serialized data may further include header encoding information of each object, pointer encoding data of each object, and at least one piece of graph attribute information, the header encoding information, the pointer encoding data, and the at least one piece of graph attribute information may also be obtained by means of deserialization processing.

The metadata of each object may be obtained according to the header encoding information, so that positions, types, and the like, of a value field and a pointer field of each object, as well as object header information, and the like, may be learned according to the metadata of each object.

Therefore, the value field data of each object may be written into a value field position in the memory address corresponding to the object according to the metadata of each object. Meanwhile, the object header information may also be written into an object header position in an internal address, and the like.

504: write, in combination with at least one piece of serialized data corresponding to the object graph, a memory address of a sub-object associated with pointer encoding data of any object as pointer field data into a memory address of the object.

Since the pointer encoding data is implemented by using the serialization number, during the deserialization processing, the pointer field encoding data of each object needs to be modified as a memory address of a sub-object associated with the object in the memory. However, in a scenario of segmented serialization of the object graph, since a sub-object associated with an object in one piece of serialized data may be in next serialized data, and the next serialized data may not be transmitted yet, the memory address of the sub-object may not be determined yet. Therefore, the pointer field position of each object in the memory address may be empty, and certainly, may alternatively be filled with the pointer field encoding data. Waiting for all serialized data to be received and in combination with the all serialized data of the object graph, the memory address of the sub-object that is associated with the pointer encoding data of any object may be determined, and the memory address is written as the pointer field data into the memory address of the object, specifically may be written into a pointer field position in the memory address. The value field position and the pointer field position may be determined according to the metadata.

In this embodiment, a serialization number corresponding to a serialization order is used as pointer field encoding data, and the serialization order is used to associate an object and a sub-object. Compared with a manner using the relative offset, graph traversal operations can be reduced, and operation complexity can be reduced, thereby helping to reduce the end-to-end delay and improve transmission efficiency. Moreover, by using the serialization order to associate the object and the sub-object, the object graph can be segmented, and at least some objects can be serialized/deserialized without waiting for all objects to be processed completely. Therefore, the end-to-end delay can be further reduced, and the transmission efficiency can be improved.

In some embodiments, in a scenario of segmented serialization of the object graph, since a sub-object associated with an object in one piece of serialized data may be in next serialized data, and the next serialized data may not be transmitted yet, the memory address of the sub-object may not be determined yet. For each piece of serialized data, a mapping relationship among the pointer encoding data, the memory address, and an offset address may be recorded. Therefore, the method may further include: determining the mapping relationship among the pointer encoding data, the memory address, and the offset address respectively corresponding to the at least some objects.

The writing, in combination with at least one piece of serialized data corresponding to the object graph, a memory address of a sub-object associated with pointer encoding data of any object as pointer field data into a memory address of the object includes: determining, according to a mapping relationship respectively corresponding to the at least one piece of serialized data, the memory address of the sub-object associated with the pointer encoding data of any object; and writing the memory address of the sub-object as the pointer field data into the memory address of the object.

The pointer field encoding data corresponds to the serialization number, and each serialization number may identify one object. Therefore, the mapping relationship may include a first correspondence between the serialization number of each object and the memory address of the object, as well as a second correspondence between the memory address of each object, and the pointer field encoding data of the object and the offset address, to which the pointer field encoding data points, of a sub-object relative to the memory address.

Therefore, the memory address of each object in the first correspondence may be calculated in combination with the second correspondence of different serialized data. The offset address corresponding to one piece of serialized data may be determined in combination with next serialized data. In this case, the offset address may be empty. Upon deserialization processing performed on the next serialized data, the offset address may be determined, and thereby, the memory address may be obtained through calculation.

For ease of understanding, in some embodiments, the determining the memory address respectively corresponding to the at least some objects may include: determining, for a first object in the at least some objects and according to the memory address of the first object and an offset address of the second object associated with the first object relative to the first object, the memory address of the second object.

The first object may be any object of the at least some objects, and for ease of description, the any object of the at least some objects is named as the first object. The second object is a sub-object of the first object.

The determining the mapping relationship among the pointer encoding data, the object address, and the offset address respectively corresponding to the at least some objects may include: determining serialization numbers respectively corresponding to the at least some objects; and determining, according to the serialization number corresponding to the pointer encoding data of the first object, the mapping relationship among the pointer encoding data, the memory address, and the offset address.

The serialization order and the deserialization order of the at least some objects are the same. The serialized data is generated from encoding data of the at least some objects according to the respective serialization orders. The deserialization processing may be performed according to the same order. Therefore, the serialization numbers respectively corresponding to the at least some objects may be determined according to the deserialization order.

If the serialization number of the first object is determined, the first correspondence may be established between the serialization number and the memory address of the first object. The offset address, to which the pointer encoding data of the first object points, of the second object relative to the first object in the memory may be determined. The memory address of the second object is equal to the memory address of the first object + the offset address of the second object. Therefore, the second correspondence among the serialization number corresponding to the pointer encoding data, the memory address, and the offset address may be established.

For ease of recording and searching, the first correspondence and the second correspondence may be recorded in different mapping tables. Therefore, in some embodiments, the determining, according to the serialization number corresponding to the pointer encoding data of the first object, the mapping relationship among the pointer encoding data, the memory address, and the offset address includes: saving the serialization number corresponding to the memory address of the first object into an address mapping table; and saving the serialization number corresponding to the pointer encoding data of the first object in correspondence with the object address of the first object and the offset address of the second object in a pointer mapping table.

The serialization number corresponding to the pointer encoding data of the first object points to the second object.

In an embodiment, an address mapping table of a corresponding size may be created in advance according to the number of objects in the at least one piece of graph attribute information corresponding to the at least some objects, and a pointer mapping table of a corresponding size may be created according to the number of the pointer field encoding data.

The determining, according to the mapping relationship respectively corresponding to the at least one piece of serialized data, the memory address of the sub-object associated with the pointer encoding data of any object includes: searching the address mapping table and the pointer mapping table respectively corresponding to the at least one piece of serialized data, and determining the memory address of the sub-object associated with the pointer encoding data of any object.

In some embodiments, the performing deserialization processing on the serialized data, to determine memory addresses of the at least some objects, and value field data respectively corresponding to the value field encoding data of the at least some objects may include: performing the deserialization processing on the serialized data, to obtain at least one piece of graph attribute information, the value field data respectively corresponding to the value field encoding data of the at least some objects included in the serialized data, and header encoding information; allocating, according to the at least one piece of graph attribute information, memory space to the at least some objects; searching for metadata of the at least some objects that is indexed by the header encoding information; and determining, based on the metadata, a memory data format respectively corresponding to the at least some objects.

Then, the writing the value field data respectively corresponding to the at least some objects into the respective memory addresses may include: writing, according to the memory data format, the value field data respectively corresponding to the at least some objects into value field positions of the respective memory addresses.

The writing, in combination with at least one piece of serialized data corresponding to the object graph, a memory address of a sub-object associated with pointer encoding data of any object as pointer field data into a memory address of the object may include: writing, in combination with the at least one piece of serialized data corresponding to the object graph and according to the memory data format, the memory address of the sub-object associated with the pointer encoding data of any object as the pointer field data into a pointer field position in the memory address of the object.

In addition, the object header information indexed by the header encoding information is written into an object header position in the memory data format.

In an embodiment, the memory space may be allocated to the at least some objects according to a graph size in the at least one piece of graph attribute information. Thereafter, the memory address respectively corresponding to the at least some objects in the memory space may be determined according to the memory data format respectively corresponding to the at least some objects and the serialization order of the at least some objects.

For ease of understanding, the object graph corresponding to the schematic diagram shown in FIG. 3 is still used as an example. Assuming that the predetermined number is 4, according to the serialization order of different objects in the object graph, after A → B → D → F is written into the first cache, first serialized data may be generated based on the value field encoding data and the pointer field encoding data of A → B → D → F, as shown in FIG. 4E. Thereafter, serialization processing may be continued on E → G → H → C, to generate second serialized data shown in FIG. 4F.

Upon receiving the first serialized data, the receiving end may perform deserialization processing on the first serialized data, create an address mapping table and a pointer mapping table, save the serialization number corresponding to the memory address of each object into the address mapping table, and correspondingly save the serialization number corresponding to the pointer encoding data of each object, the memory address of each object, and the offset address of the sub-object to which the pointer encoding data of each object points into the pointer mapping table.

After receiving second sequence data, the receiving end may perform the same operation to obtain the address mapping table and the pointer mapping table.

**Table 1 below shows an implementation of the address mapping table corresponding to the first serialized data:**

| | |
|---|---|
| 0 | Addr-A |
| 1 | Addr-B |
| 2 | Addr-D |
| 3 | Addr-F |

| | |
|---|---|
| where Addr-A represents a memory address of an object A, Addr-B represents a memory address of an object B, Addr-D represents a memory address of an object D, and Addr-F represents a memory address of an object F. | |

**Table 2 below shows an implementation of the pointer mapping table of the first serialized data:**

| | |
|---|---|
| Addr-A+offsetAl | 1 |
| Addr-A+offsetA2 | 2 |
| Addr-B+offset B1 | 3 |
| Addr-D+offset D1 | 4 |
| Addr-F+offset F1 | 3 |

| | |
|---|---|
| where offsetA1 represents an offset address of a first sub-object (that is, the object B) of the object A, offsetA2 represents an offset address of a second sub-object (that is, the object D) of the object A, offsetB1 represents an offset address of a first sub-object of the object B, offseD1 represents an offset address of a first sub-object of the object D, and offseF1 represents an offset address of a first sub-object of the object F. | |

**Table 3 below shows an implementation of the address mapping table corresponding to the second serialized data:**

| | |
|---|---|
| 4 | Addr-E |
| 5 | Addr-G |
| 6 | Addr-H |
| 7 | Addr-C |

| | |
|---|---|
| where Addr-E represents a memory address of an object E, Addr-G represents a memory address of an object G, Addr-H represents a memory address of an object H, and Addr-C represents a memory address of an object C. | |

**Table 4 below shows an implementation of the pointer mapping table corresponding to the second serialized data:**

| | |
|---|---|
| Addr-E+offset E1 | 1 |
| Addr-E+offset E2 | 5 |
| Addr-G+offset G1 | 5 |
| Addr-G+offset G2 | 7 |
| Addr-H+offset H1 | 1 |
| Addr-H+offset H2 | 5 |
| Addr-H+offset H3 | 0 |
| Addr-C+offset C1 | 5 |
| Addr-C+offset C2 | 6 |

| | |
|---|---|
| where offsetE1 represents an offset address of a first sub-object of the object A, offsetE2 represents an offset address of a second sub-object of the object E, offsetG1 represents an offset address of a first sub-object of the object G, and offsetG2 represents an offset address of a second sub-object of the object G, offsetH1 represents an offset address of a first sub-object of the object H, offsetH2 represents an offset address of a second sub-object of the object H, offsetH3 represents an offset address of a third sub-object of the object H, offsetC1 represents an offset address of a first sub-object of the object C, and offsetC2 represents an offset address of a second sub-object of the object C. | |

It can be known in combination with Table 1 to Table 4 that, the object A is a first deserialized object, and the serialization number corresponding to the object A may be 0. The object A may first be written into the memory space to learn the memory address (Addr-A) corresponding to the object A. The object B is a sub-object of the object A, and is a next deserialized object after the object A. The serialization number of the object B is 1. The object B is written into the memory space, and the offset address (offsetA1) of the object B relative to the object A can be determined. The memory address (Addr-B) of the object B is equal to the memory address (Addr-A) of the object A plus the offset address (offsetA1) of the object B.

The serialization number 4 of the object E corresponds to the memory address (Addr-D) of the object D and the offset address (offsetD1) of a sub-object of the object D. The serialization number 4 identifies the serialization order of the sub-object. The memory address (Addr-D) of the object D plus the offset address (offsetD1) of the sub-object of the object D is the memory address (Addr-E) of the sub-object corresponding to the serialization number 4.

The first serialized data does not include the object E corresponding to the serialization number 4, and the memory address (Addr-E) and the offset address (offsetD1) of the object E can not be determined. Therefore, the memory address (Addr-D) and the offset address (offsetD1) of the object E may be determined in combination with a deserialization result of the second serialized data, and may be further filled in Table 2, Table 3, and the like

Finally, by looking up Table 1 to Table 4, the pointer field encoding data of each object may be modified as a memory address corresponding to a corresponding serialization number, and the memory address may be written into a pointer field position in the memory address corresponding to each object, so as to finally obtain an object graph after deserialization.

FIG. 6A shows a memory data format of an object in an object graph after deserialization. Metadata used for indicating positions and types of a value field and a pointer field in the object is assumed to be represented by a bitmap "01100". 0 represents that the position corresponds to the value field, and 1 represents that the position corresponds to the pointer field. A corresponding memory data format is shown in FIG. 6. In the memory data format, H represents an object header position, V represents a value field position, P represents a pointer field position, and so on. The pointer field data written into the pointer field position is a memory address of an associated sub-object, and may be the same as the memory data format in the sending end.

In addition, FIG. 6B shows a schematic diagram of a segmented serialization/deserialization operation on an object graph. It can be known in combination with FIG. 6B that, the sending end may perform serialization processing 60 based on some objects, to generate a piece of serialized data. Each piece of serialized data may be transmitted to the receiving end upon generation. The receiving end may perform deserialization processing 61 on each piece of serialized data upon receipt, without waiting for all serialized data. Finally, the pointer field data is updated 62 in combination with all received serialized data, so that the object graph may be restored.

Through the technical solution in the embodiment of the present application, an object serialization/deserialization order is used to replace a relative offset in conventional serialization encoding to associate an object and a sub-object of the object, thereby eliminating a limitation that deserialization needs to wait until serialization is completely completed and an entire serialization buffer is completely received before deserialization can begin, enabling overlapping implementation of serialization, network transmission, and deserialization, and eliminating a requirement of modifying a relative offset in a serialization process, thereby reducing end-to-end delay of serialization/deserialization, improving processing efficiency, and ensuring user experience.

In the embodiment of the present application, the sending end: determines, for any object in an object graph, that is, a first object, and according to a serialization order of a second object associated with the first object, a serialization number of the second object; uses the serialization number of the second object as pointer field encoding data of the first object; determines, according to the serialization order of different objects in the object graph, at least some objects to be serialized; generates, based on value field encoding data and pointer field encoding data of the at least some objects, serialized data of the at least some objects; and transmits the serialized data to a receiving end. The receiving end is configured to obtain the object graph in combination with a deserialization result of at least one piece of serialized data corresponding to the object graph. By using the serialization number corresponding to the serialization order as the pointer field encoding data and using the serialization order to associate an object and a sub-object, compared with a manner using the relative offset, there is no need to traverse all objects to determine the relative offset of the sub-object. Therefore, graph traversal operations can be reduced, and operation complexity can be reduced, thereby helping to reduce the end-to-end delay and improve transmission efficiency. Moreover, by using the serialization order to associate the object and the sub-object, some objects can be serialized/deserialized without waiting for all objects to be processed completely. Therefore, the end-to-end delay can be further reduced, and processing efficiency can be improved.

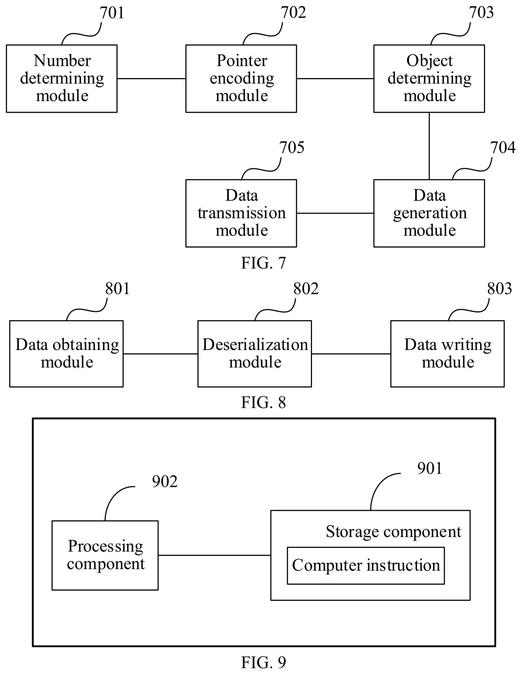

FIG. 7 is a schematic structural diagram of an embodiment of an object processing apparatus according to an embodiment of the present application. The apparatus may include: a number determining module 701, configured to determine, according to a serialization order of a second object associated with a first object in an object graph, a serialization number of the second object; a pointer encoding module 702, configured to use the serialization number of the second object as pointer field encoding data of the first object; and an object determining module 703, configured to determine, according to a serialization order of different objects in the object graph, at least some objects to be serialized in the object graph; a data generation module 704, configured to generate, based on value field encoding data and pointer field encoding data of the at least some objects, serialized data of the at least some objects; and a data transmission module 705, configured to transmit the serialized data to a receiving end. The receiving end is configured to obtain the object graph in combination with a deserialization result of at least one piece of serialized data corresponding to the object graph.

In some embodiments, the object determining module may specifically: write, according to the serialization order of the different objects in the object graph, value field encoding data and the pointer field encoding data of the first object into a first cache; and use, when the first cache reaches a predetermined cache size or a number of objects that have been written reaches a predetermined number, the objects that have been written into the first cache as the at least some objects to be serialized.

In some embodiments, the apparatus may further include: an object division module, configured to segment, according to the serialization order of the different objects in the object graph and in combination with a predetermined cache size or a predetermined number of objects, the object graph, to obtain a plurality of sub-object graphs. The pointer encoding module may specifically determine, according to the serialization order of the second object associated with the first object in a first sub-object graph, the serialization number of the second object. The object determining module may specifically use at least one object included in the first sub-object graph as the at least some objects to be serialized.

In some embodiments, the data generation module specifically: writes the value field encoding data respectively corresponding to the at least some objects into respectively corresponding value field positions in a predetermined data format; writes the pointer field encoding data respectively corresponding to the at least some objects into respectively corresponding pointer field positions in the predetermined data format; writes header encoding information respectively corresponding to the at least some objects into respectively corresponding header positions in the predetermined data format, where the header encoding information is used for associating metadata; and writes at least one piece of graph attribute information corresponding to the at least some objects into an attribute position in the predetermined data format.

In some embodiments, the data generation module may specifically: combine the value field encoding data and header encoding information respectively corresponding to the at least some objects, to obtain a value field encoding array; combine the pointer field encoding data respectively corresponding to the at least some objects, to obtain a pointer field encoding array; combine at least one piece of graph attribute information corresponding to the at least some objects, to obtain an attribute encoding array; and use the value field encoding array, the pointer field encoding array, and the attribute encoding array as the serialized data.

In some embodiments, the apparatus may further include: an object graph determining module. The object graph determining module is configured to: determine, in response to a data transmission operation for a previous second sub-object graph, a next first sub-object graph to be serialized; or perform parallel processing on the plurality of sub-object graphs, and use any sub-object graph as the first sub-object graph; or determine, in response to that determining duration for which the previous second object graph is determined as a sub-object graph to be serialized is greater than predetermined duration, a next first sub-object graph to be serialized.

The object processing apparatus in FIG. 7 may perform the object processing method in the embodiment shown in FIG. 2. An implementation principle and a technical effect of the object processing apparatus are not described in detail again. Specific manners of performing operations by the modules and units of the object processing apparatus in the foregoing embodiments have been described in detail in the embodiments related to the method, and are not illustrated in detail here.

FIG. 8 is a schematic structural diagram of another embodiment of an object processing apparatus according to an embodiment of the present application. The apparatus may include: a data obtaining module 801, configured to obtain serialized data transmitted by a sending end, where the serialized data is generated based on value field encoding data and pointer field encoding data of at least some objects in an object graph, and the pointer field encoding data is a serialization number of an associated sub-object; a deserialization module 802, configured to perform deserialization processing on the serialized data, to determine memory addresses of the at least some objects, and value field data respectively corresponding to the value field encoding data of the at least some objects; and a data writing module 803, configured to write the value field data respectively corresponding to the at least some objects into the respective memory addresses, and write, in combination with at least one piece of serialized data corresponding to the object graph, a memory address of a sub-object associated with pointer encoding data of any object as pointer field data into a memory address of the object.

In some embodiments, the apparatus may further include: a relationship recording module, configured to determine a mapping relationship among the pointer encoding data, the memory address, and an offset address respectively corresponding to the at least some objects. The data writing module may specifically: determine, according to a mapping relationship respectively corresponding to the at least one piece of serialized data, the memory address of the sub-object associated with the pointer encoding data of any object; and write the memory address of the sub-object as the pointer field data into the memory address of the object.

In some embodiments, the determining, by the deserialization module, the memory addresses respectively corresponding to the at least some objects may include: determining, for a first object in the at least some objects and according to the memory address of the first object and an offset address of the second object associated with the first object relative to the first object, the memory address of the second object. The relationship recording module may specifically: determine serialization numbers respectively corresponding to the at least some objects; and determine, according to the serialization number corresponding to the pointer encoding data of the first object, the mapping relationship among the pointer encoding data, the memory address, and the offset address.

In some embodiments, the determining, by the relationship recording module and according to a serialization number corresponding to the pointer encoding data of the first object, the mapping relationship among the pointer encoding data, the memory address, and the offset address includes: saving the serialization number corresponding to the memory address of the first object into an address mapping table; and saving the serialization number corresponding to the pointer encoding data of the first object in correspondence with the object address of the first object and the offset address of the second object in a pointer mapping table. The determining, by the data writing module and according to the mapping relationship respectively corresponding to the at least one piece of serialized data, the memory address of the sub-object associated with the pointer encoding data of any object includes: searching the address mapping table and the pointer mapping table respectively corresponding to the at least one piece of serialized data, and determining the memory address of the sub-object associated with the pointer encoding data of any object.

In some embodiments, the deserialization module specifically: allocates, according to the at least one piece of graph attribute information, memory space to the at least some objects; searches for metadata of the at least some objects that is indexed by the header encoding information; and determines, based on the metadata, memory data formats respectively corresponding to the at least some objects. The writing, by the data writing module, the value field data respectively corresponding to the at least some objects into the respective memory addresses includes: writing, according to the memory data format, the value field data respectively corresponding to the at least some objects into value field positions of the respective memory addresses. The writing, by the data writing module and in combination with at least one piece of serialized data corresponding to the object graph, a memory address of a sub-object associated with pointer encoding data of any object as the pointer field data into a memory address of the object includes: writing, in combination with the at least one piece of serialized data corresponding to the object graph and according to the memory data format, the memory address of the sub-object associated with the pointer encoding data of any object as the pointer field data into a pointer field position in the memory address of the object.

The object processing apparatus in FIG. 8 may perform the object processing method in the embodiment shown in FIG. 5. An implementation principle and a technical effect of the object processing apparatus are not described in detail again. Specific manners of performing operations by the modules and units of the object processing apparatus in the foregoing embodiments have been described in detail in the embodiments related to the method, and are not illustrated in detail here.

An embodiment of the present application further provides a computing device. As shown in FIG. 9, the computing device may include a storage component 901 and a processing component 902. The storage component 901 stores one or more computer instructions, and the one or more computer instructions are invoked and executed by the processing component 902, to implement the object processing method shown in FIG. 2 or the object processing method shown in FIG. 5.

Certainly, the computing device may further include other components, such as an input/output interface, a display component, a communication component, or the like.

The input/output interface provides an interface between the processing component and a peripheral interface module. The foregoing peripheral interface module may be an output device, an input device, or the like. The communication component is configured to facilitate communication in a wired or wireless manner between the computing device and another device.

The processing component may include one or more processors to execute a computer instruction, to complete all or some steps in the foregoing method. Certainly, the processing component may alternatively be implemented by one or more application-specific integrated circuits (ASICs), digital signal processors (DSPs), digital signal processing devices (DSPDs), programmable logic devices (PLDs), field programmable gate arrays (FPGAs), controllers, microcontrollers, microprocessors, or other electronic elements, to perform the foregoing method.

The storage component is configured to store various types of data to support operations at a terminal. The storage component may be implemented by any type of volatile or non-volatile storage device or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic disk, or an optical disc.

It should be noted that the foregoing computing device may be a physical device, an elastic computing host provided by a cloud computing platform, or the like. The computing device may be implemented as a distributed cluster including a plurality of servers or terminal devices, or may be implemented as a single server or a single terminal device.

The foregoing computing device may alternatively be specifically implemented as an electronic device. The electronic device may refer to a device used by a user and having functions, such as computing, network access, and communication required by the user, and may be, for example, a mobile phone, a tablet computer, a personal computer, a wearable device, or the like.

An embodiment of the present application further provides a computer readable storage medium, storing a computer program. The computer program, when executed by a computer, may implement the object processing method in the embodiment shown in FIG. 2 above or the object processing method in the embodiment shown in FIG. 5 above. The computer readable medium may be included in the electronic device described in the foregoing embodiment. Alternatively, the computer readable medium may exist alone and is not assembled into the electronic device.

An embodiment of the present application further provides a computer program product, including a computer program carried in a computer readable storage medium. The computer program, when executed by a computer, may implement the object processing method in the embodiment shown in FIG. 2 above or the object processing method in the embodiment shown in FIG. 5 above. In such an embodiment, the computer program may be downloaded and installed from a network, and/or installed from a removable medium. When the computer program is executed by the processor, various functions defined in the system of the present application are performed.

It should be noted that the embodiment of the present application may involve use of user data. In a practical application, user-specific personal data may be used in the solution described herein in a case in which applicable legal and legal requirements of a country are satisfied (for example, the user explicitly agrees, or the user is actually notified) and within a scope allowed by the applicable legal and legal requirements.

A person skilled in the art may clearly understand that, for convenient and concise description, a specific working process of the foregoing described system, apparatus, and unit may refer to a corresponding process in the foregoing method embodiment, and details are not described herein again.

The above described apparatus embodiments are merely exemplary. The units illustrated as separate parts may or may not be physically separate. The parts displayed as units may or may not be physical units, that is, may be located in one location or may be distributed across a plurality of network units. Some or all of the modules may be selected according to actual needs to achieve the objectives of the solutions of the embodiments. A person of ordinary skill in the art may understand and implement the above without making creative efforts.

Based on the description of the foregoing implementations, a person skilled in the art may clearly understand that the implementations may be implemented by a software in addition to a necessary universal hardware platform, or certainly, may be implemented by a hardware. Based on such an understanding, the foregoing technical solutions essentially, or the part contributing to related art may be implemented in a form of a software product. The computer software product may be stored in a computer readable storage medium, such as a ROM/RAM, a magnetic disk, an optical disc, or the like, and includes several instructions for enabling a computer device (which may be a personal computer, a server, a network device, or the like) to perform the methods described in the embodiments or some parts of the embodiments.

Finally, it should be noted that the foregoing embodiments are merely used for illustrating the technical solutions of the present application, rather than limiting the technical solutions of the present application. Although the present application is illustrated in detail with reference to the foregoing embodiments, persons of ordinary skill in the art should understand that they may still make modifications to the technical solutions described in the foregoing embodiments, or make equivalent replacements to some technical features thereof. These modifications or replacements do not cause the essence of corresponding technical solutions to depart from the spirit and scope of the technical solutions of the embodiments of the present application.

## Claims

1. An object processing method, comprising:
determining, according to a serialization order of a second object associated with a first object in an object graph, a serialization number of the second object;
using the serialization number of the second object as pointer field encoding data of the first object;
determining, according to a serialization order of different objects in the object graph, at least some objects to be serialized in the object graph;
generating, based on value field encoding data and pointer field encoding data of the at least some objects, serialized data of the at least some objects;
transmitting the serialized data to a receiving end, wherein the receiving end is used to obtain the object graph in combination with a deserialization result of at least one piece of serialized data corresponding to the object graph.

2. The method according to claim 1, wherein the determining, according to the serialization order of the different objects in the object graph, the at least some objects to be serialized comprises:
writing, according to the serialization order of the different objects in the object graph, value field encoding data and the pointer field encoding data of the first object into a first cache;
using, when the first cache reaches a predetermined cache size or a number of objects that have been written reaches a predetermined number, the objects that have been written into the first cache as the at least some objects to be serialized.

3. The method according to claim 1, further comprising:
segmenting, according to the serialization order of the different objects in the object graph and in combination with a predetermined cache size or a predetermined number of objects, the object graph, to obtain a plurality of sub-object graphs, wherein,
the determining, according to the serialization order of the second object associated with the first object in the object graph, the serialization number of the second object comprises:
determining, according to the serialization order of the second object associated with the first object in a first sub-object graph, the serialization number of the second object;
the determining, according to the serialization order of the different objects in the object graph, the at least some objects to be serialized comprises:
using at least one object comprised in the first sub-object graph as the at least some objects to be serialized.

4. The method according to claim 1, wherein the generating, based on the value field encoding data and the pointer field encoding data of the at least some objects, the serialized data of the at least some objects comprises:
writing the value field encoding data respectively corresponding to the at least some objects into respectively corresponding value field positions in a predetermined data format;
writing the pointer field encoding data respectively corresponding to the at least some objects into respectively corresponding pointer field positions in the predetermined data format;
writing header encoding information respectively corresponding to the at least some objects into respectively corresponding header positions in the predetermined data format, wherein the header encoding information is used for associating metadata;
writing at least one piece of graph attribute information corresponding to the at least some objects into an attribute position in the predetermined data format.

5. The method according to claim 1, wherein the generating, based on the value field encoding data and the pointer field encoding data of the at least some objects, the serialized data of the at least some objects comprises:
combining the value field encoding data and header encoding information respectively corresponding to the at least some objects, to obtain a value field encoding array;
combining the pointer field encoding data respectively corresponding to the at least some objects, to obtain a pointer field encoding array;
combining at least one piece of graph attribute information corresponding to the at least some objects, to obtain an attribute encoding array;
using the value field encoding array, the pointer field encoding array, and the attribute encoding array as the serialized data.

6. The method according to claim 3, further comprising:
determining, in response to a data transmission operation for a previous second sub-object graph, a next first sub-object graph to be serialized; or
performing parallel processing on the plurality of sub-object graphs, and using any sub-object graph as the first sub-object graph; or
determining, in response to that determining duration for which the previous second object graph is determined as a sub-object graph to be serialized is greater than predetermined duration, a next first sub-object graph to be serialized.

7. An object processing method, comprising:
obtaining serialized data transmitted by a sending end, wherein the serialized data is generated based on value field encoding data and pointer field encoding data of at least some objects in an object graph, and the pointer field encoding data is a serialization number of an associated sub-object;
performing deserialization processing on the serialized data, to determine memory addresses of the at least some objects, and value field data respectively corresponding to the value field encoding data of the at least some objects;
writing the value field data respectively corresponding to the at least some objects into respective memory addresses;
writing, in combination with at least one piece of serialized data corresponding to the object graph, a memory address of a sub-object associated with pointer encoding data of any object as pointer field data into a memory address of the object.

8. The method according to claim 7, further comprising:
determining a mapping relationship among the pointer encoding data, the memory address, and an offset address respectively corresponding to the at least some objects, wherein
the writing, in combination with the at least one piece of serialized data corresponding to the object graph, the memory address of the sub-object associated with the pointer encoding data of any object as the pointer field data into the memory address of the object comprises:
determining, according to a mapping relationship respectively corresponding to the at least one piece of serialized data, the memory address of the sub-object associated with the pointer encoding data of any object;
writing the memory address of the sub-object as the pointer field data into the memory address of the object.

9. The method according to claim 8, wherein the determining the memory address respectively corresponding to the at least some objects comprises:
determining, for a first object in the at least some objects and according to the memory address of the first object and an offset address of the second object associated with the first object relative to the first object, the memory address of the second object, wherein
the determining the mapping relationship among the pointer encoding data, an object address, and the offset address respectively corresponding to the at least some objects comprises:
determining serialization numbers respectively corresponding to the at least some objects;
determining, according to the serialization number corresponding to the pointer encoding data of the first object, the mapping relationship among the pointer encoding data, the memory address, and the offset address.

10. The method according to claim 9, wherein the determining, according to the serialization number corresponding to the pointer encoding data of the first object, the mapping relationship among the pointer encoding data, the memory address, and the offset address comprises:
saving the serialization number corresponding to the memory address of the first object into an address mapping table;
saving the serialization number corresponding to the pointer encoding data of the first object in correspondence with the object address of the first object and the offset address of the second object in a pointer mapping table, wherein
the determining, according to the mapping relationship respectively corresponding to the at least one piece of serialized data, the memory address of the sub-object associated with the pointer encoding data of any object comprises:
searching the address mapping table and the pointer mapping table respectively corresponding to the at least one piece of serialized data, and determining the memory address of the sub-object associated with the pointer encoding data of any object.

11. The method according to claim 8, wherein the performing the deserialization processing on the serialized data, to determine the memory addresses of the at least some objects, and the value field data respectively corresponding to the value field encoding data of the at least some objects comprises:
performing the deserialization processing on the serialized data, to obtain at least one piece of graph attribute information, the value field data respectively corresponding to the value field encoding data of the at least some objects comprised in the serialized data, and header encoding information;
allocating, according to the at least one piece of graph attribute information, memory space to the at least some objects;
searching for metadata of the at least some objects that is indexed by the header encoding information;
determining, based on the metadata, memory data formats respectively corresponding to the at least some objects;
wherein the writing the value field data respectively corresponding to the at least some objects into the respective memory addresses comprises:
writing, according to the memory data format, the value field data respectively corresponding to the at least some objects into value field positions of the respective memory addresses;
wherein the writing, in combination with the at least one piece of serialized data corresponding to the object graph, the memory address of the sub-object associated with the pointer encoding data of any object as the pointer field data into the memory address of the object comprises:
writing, in combination with the at least one piece of serialized data corresponding to the object graph and according to the memory data format, the memory address of the sub-object associated with the pointer encoding data of any object as the pointer field data into a pointer field position in the memory address of the object.

12. A computing device, comprising a processing component and a storage component, wherein the storage component stores one or more computer instructions, and the one or more computer instructions are used to be invoked and executed by the processing component, to implement the object processing method according to any one of claims 1 to 6 or implement the object processing method according to any one of claims 7 to 11.

13. A computer readable storage medium, storing a computer program, wherein the computer program, when executed by a computer, implements the object processing method according to any one of claims 1 to 6 or implements the object processing method according to any one of claims 7 to 11.
